# EUROPÄISCHE PATENTSCHRIFT

(11) **EP 1 284 095 B1**
(45) Veröffentlichungstag und Bekanntmachung des Hinweises auf die Patenterteilung: **06.10.2004**
(21) Anmeldenummer: 01943145.1
(22) Anmeldetag: 23.05.2001
(51) Int. Cl.: H05K 13/04

(54) **VORRICHTUNG ZUM BESTÜCKEN VON SUBSTRATEN MIT ELEKTRISCHEN BAUTEILEN**
DEVICE FOR FITTING SUBSTRATES WITH ELECTRIC COMPONENTS
DISPOSITIF POUR IMPLANTER DES COMPOSANTS ELECTRIQUES SUR DES SUBSTRATS

(30) Priorität: 23.05.2000 DE 10025443
(43) Veröffentlichungstag der Anmeldung: 19.02.2003
(73) Patentinhaber: Siemens Aktiengesellschaft, 80333 München (DE)
(72) Erfinder: SCHULZ, Ralf, 81241 München (DE); MEHDIANPOUR, Mohammad, 81829 München (DE)
(86) Internationale Anmeldenummer: PCT/DE2001/001981
(87) Internationale Veröffentlichungsnummer: WO 2001/091532

(56) Entgegenhaltungen:
- US-A- 5 778 525

## Beschreibung

Die Erfindung bezieht sich auf eine Vorrichtung zum Bestücken von Substraten mit elektrischen Bauteilen, wobei die Vorrichtung zumindest eine Positioniereinrichtung für einen in zwei Koordinatenrichtungen verfahrbaren Bestückkopf zum Handhaben der Bauteile aufweist.

Eine derartige Vorrichtung ist zum Beispiel durch die WO 9837744 A1 bekannt geworden. Danach weist die Vorrichtung einen Lineartransport mit zwei Bestückplätzen für die Substrate auf. Zwischen den beiden Bestückplätzen erstreckt sich ein balkenartiger Träger quer zur Transportrichtung der Susbtrate. An den Träger sind zu beiden Seiten X-Y-Positioniereinrichtungen angesetzt, die die Bestückplätze und die Abholstellen für die Bauteile überdecken. Die Positioniereinrichtung besteht aus einer am Träger befestigten, mit Magnetteilen versehenen Längsführung, entlang der ein senkrecht stehender, mit einem Spulenteil versehener Positionierarm verfahrbar ist, an dem ein Bestückkopf zum Handhaben der Bauteile verfahrbar ist. Der einseitig verankerte Positionierarm weist eine relativ große freie Länge auf. Rapide Beschleunigungs- und insbesondere Bremsvorgänge führen zu Schwingungen im Positionierarm, die insbesondere dann stören, wenn sich der Bestückkopf in dessen Endbereich befindet. Diese Schwingungen müssen bei jedem Abhol- oder Bestückvorgang zunächst abgeklungen sein, bevor diese Vorgänge durchgeführt werden können.

Zuführmodule für die Bauelemente sind in der Richtung der Positionierarme zu beiden Seiten der Transportstrecke aneinandergereiht. Da die Positionierarme nicht zu lang werden dürfen, ist auch die Anzahl der Zuführmodule und damit die bereitstellbare Bauteilevielfalt begrenzt.

Der Erfindung liegt die Aufgabe zugrunde, eine Vorrichtung zu schaffen, die bei kompakter Bauweise eine schwingungsarme Lagerung des Bestückkopfes ermöglicht.

Diese Aufgabe wird durch die Erfindung gemäß Anspruch 1 gelöst. Da nun der Bestückkopf nicht mehr seitlich der Bestückplätze, sondern über diesen angeordnet ist, kann auch die stationäre Längsführung durch die Mitte des Verfahrbereiches angeordnet werden, so daß der verfahrbare Positionierarm in einem mittleren Abschnitt z.B. durch einen integrierten Linearmotor angetrieben, geführt und abgestützt werden kann. Die freiragenden Abschnitte verteilen sich somit auf beide Seiten der Längsführung und bleiben entsprechend kurz und biegesteif. Durch eine Anordnung der Positionierachsen im Mittelbereich des Bestückfeldes ergeben sich sehr kurze Hebelarme beim Bestücken, was die Bestückgenauigkeit erhöht.

Durch die Anordnung des Trägers oberhalb der Bestückebene bedarf es keiner Stützstrukturen im Verfahrbereich des Bestückkopfes, so daß die Zuführeinrichtungen für die Bauelemente eng an die Bestückplätze herangeführt werden können. Aufgrund der günstigen Lagerungsverhältnisse kann der Verfahrbereich in der Reihenrichtung der Zuführmodule so weit vergrößert werden, daß eine erheblich größere Anzahl der Zuführmodule angesetzt werden kann.

Der formstabile Träger kann durch die Endstützen und die Mittelstützen fest mit dem Chassis verbunden werden, so daß eine schwingungsarme Überleitung der Beschleunigungs- und Bremskräfte in das Chassis möglich ist.

Vorteilhafte Weiterbildungen der Erfindung sind in den Unteransprüchen gekennzeichnet:

Die wandartigen Mittelstützen nach Anspruch 2 versteifen durch ihre Erstreckung in der Transportrichtung die Abstützung des Trägers besonders in dieser Richtung. Durch ihre schräge Neigung wird der Träger im Mittelbereich auch in der Querrichtung besonders gut abgestützt.

Die wandartigen Endstützen nach Anspruch 3 versteifen die Struktur quer zur Transportrichtung der Substrate.

Die relativ schlanken Stützen können in engem Abstand zum äußeren Rand der Verfahrbereichs angeordnet werden, was entsprechend kompakte Außenabmessungen zuläßt.

Der plattenartige Träger nach Anspruch 4 ist in der Verfahrrichtung besonders biegesteif und entsprechend schwingungsarm. Die Freimachungen in den Eckbereichen erleichtern den Zugang zum Innenraum der Vorrichtung.

Das Chassis nach Anspruch 5 ist der Lage der Stützen angepaßt. Die Innenecken der kreuzförmigen Struktur dienen der Aufnahme von Zuführmodulen für die bereitzustellenden Bauteile.

Das schwingungsarme Gußteil nach Anspruch 6 läßt sich kostengünstig herstellen.

In den hohlen Grundkörper nach Anspruch 7 können zum Beispiel pneumatische Aggregate oder Aggregate zur Stromversorgung eingesetzt werden.

Der sich unterhalb der Förderstrecke erstreckende Hohlraum des Grundkörpers nach Anspruch 8 kann zum Einbau einer zusätzlichen Transportstrecke dienen, auf der Substrate an den Bestückplätzen der Vorrichtung vorbeigeschleust werden können.

Der plattenartige Träger nach Anspruch 9 hat den Vorteil, daß unterschiedliche Positioniereinrichtungen in unterschiedlicher Konfiguration montiert werden können.

Beispielsweise kann nach Anspruch 10 die feste Längsachse der Positioniereinrichtung parallel zur Förderrichtung orientiert sein, wobei der Positionierarm beide Zuführbereiche für die Bauteile überdeckt.

Es ist aber auch nach Anspruch 11 möglich, die feste Längsführung quer zur Förderrichtung über dem Bestückplatz anzuordnen, wodurch die Positionierarme kürzer gehalten werden können. Durch die Anordnung von zwei Positionierarmen auf der gemeinsamen Längsführung kann die Bestückleistung erheblich gesteigert werden, indem die beiden Positioniereinrichtungen wechselweise die Bauteile abholen, bzw. auf das Substrat aufsetzen.

Durch die Weiterbildung nach Anspruch 12 können die Bedienund Steuergeräte in enger Zuordnung zu den Positioniereinrichtungen gut zugänglich angeordnet werden.

Im folgenden wird die Erfindung anhand von in der Zeichnung dargestellten Ausführungsbeispielen näher erläutert.
Figur 1 zeigt in einer schematisierten perspektivischen Ansicht eine Vorrichtung zum Bestücken von Substraten mit elektrischen Bauteilen,
Figur 2 einen Teilschnitt durch die Vorrichtung nach Figur 1.
Figur 3 einen Teilschnitt durch eine modifizierte Vorrichtung nach Figur 1

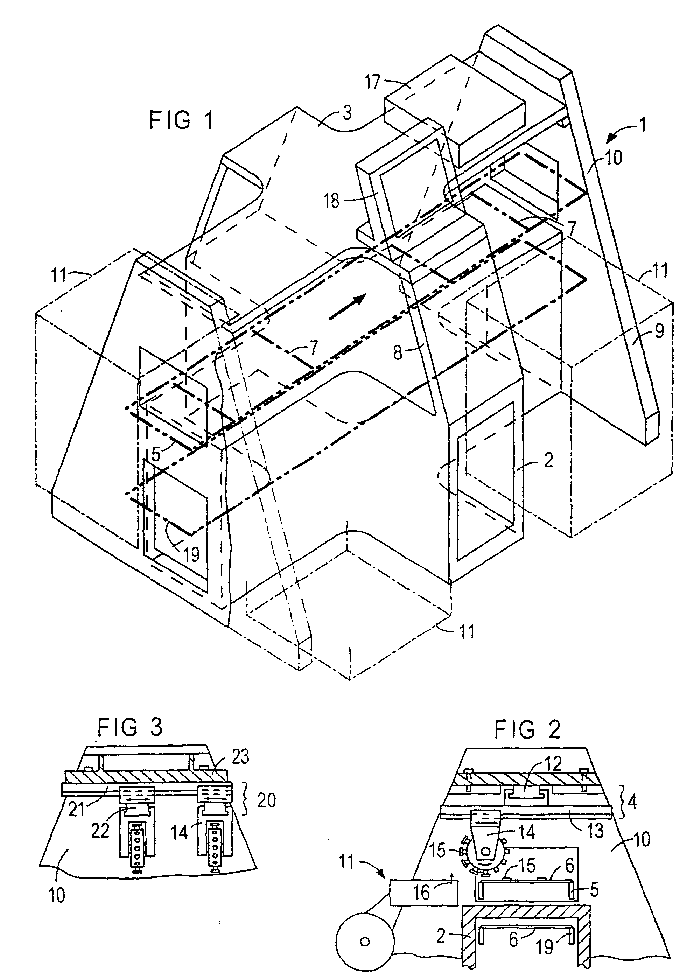

Nach den Figuren 1 und 2 besteht ein Chassis 1 einer Vorrichtung zum Bestücken von Substraten 6 mit elektrischen Bauteilen 15 aus einem gegossenen Grundkörper 2 und einem daran befestigten plattenartigen Träger 3, an dem eine X-Y-Positioniereinrichtung 4 gelagert ist. Über dem Grundkörper 2 ist durch die Vorrichtung eine Förderstrecke 5 für die Substrate 6 hindurchgeführt, die in Bestückplätzen 7 der Förderstrecke 5 mit den Bauteilen bestückbar sind.

Der Grundkörper 2 weist in der Draufsicht eine kreuzförmige Struktur auf, bei der sich ein Hauptschenkel parallel zur Förderstrecke 5 und unterhalb von dieser erstreckt. Ein Mittelschenkel erstreckt sich quer zur Transportrichtung im Mittelbereich des Hauptschenkels. An seinen Enden sind wandartige, schräg gegeneinander nach oben ragende Mittelstützen 8 für den Träger 3 angegossen. An den Enden der Hauptschenkel sind einstückig angesetzte Stirnwände 9 vorgesehen, die oberhalb des Grundkörpers 2 zu Endstützen 10 für den Träger 3 erweitert sind. In den Eckbereichen zwischen den Schenkeln des Grundkörpers 2 sind Stellplätze für Zuführeinrichtungen 11 für die zu bestückenden Bauteile angeordnet. Die Oberseiten der Zuführeinrichtungen 11 befinden sich im gleichen Höhenniveau wie das Substrat 6.

Der plattenartige Träger 3 ist mit Abstand oberhalb der Förderstrecke 5 angeordnet. Auf seiner Unterseite ist die Positioniereinrichtung 4 gelagert, die aus einer auf der Unterseite des Trägers 3 befestigten, sich in der Förderrichtung erstreckenden Längsführung 12 und einem dazu querstehenden Positionierarm 13 besteht, der in der Längsführung 12 verschiebbar gelagert ist. Diese ist z.B. mit Magnetteilen versehen, die zusammen mit einem Spulenteil des Positionierarms 13 einen Linearmotor bilden, der den Positionierarm antreibt.

Auf der Unterseite des Positionierarms ist ein revolverartiger Bestückkopf 14 verschiebbar gelagert, mit dessen Hilfe die Bauteile 15 von Abholplätzen 16 der Zuführeinrichtungen 11 zu ihren Aufsetzstellen auf dem Substrat transportiert werden können. Die Mittelstützen 8 sind in der Förderrichtung so breit und biegesteif, daß sie durch die Bewegung des Positionierarms hervorgerufene Schwingungen wirksam verhindern. In der Querrichtung durch die Bewegung des Bestückkopfes ausgelöste Impulse werden durch die stirnseitigen Endstützen wirksam verhindert. Um eine möglichst große Bestückleistung zu erreichen, ist es zweckmäßig, für jeden Bestückplatz eine eigene Positioniereinrichtung 4 zuzuordnen.

Auf der Oberseite des Trägers 3 sind Stellplätze für Hilfseinrichtungen, zum Beispiel in Form eines Steuergeräts 17 und eines Displays 18 vorgesehen. Der Grundkörper 2 ist als gegossener Hohlkörper ausgebildet, durch dessen Hauptschenkel eine zusätzliche Transportstrecke 19 für die Substrate 6 hindurchgeführt ist. Diese Förderstrecke dient zum Beispiel dazu, Substrate an den Bestückplätzen vorbeizuschleusen. Die Hohlräume in den mittleren Nebenschenkeln können zum Beispiel dazu dienen, Stromversorgungsaggregate, pneumatische Einrichtungen oder weitere Steuergeräte aufzunehmen.

Die Vorrichtung nach Figur 3 unterscheidet sich von der nach Figur 2 durch die Anordnung der Positionierachsen. Die abgewandelten Längsführungen 21 erstrecken sich hier quer zu Förderrichtung der Substrate über jedem der Bestückplätze und sind an einem abgewandelten, durch Rippen verstärkten Träger 23 befestigt. Auf der Längsführung 21 sind zwei modifizierte Positionierarme 22 mit je einem der Bestückköpfe 14 verfahrbar. Diese bilden zwei Positioniereinrichtungen 20, die wechselweise Bauteile abholen bzw. auf das Substrat aufsetzen können, wodurch sich die Bestückleistung erheblich erhöht.

## Patentansprüche

1. Vorrichtung zum Bestücken von Substraten (6) mit elektrischen Bauteilen (15),
wobei die Substrate (6) durch die Vorrichtung auf einer linearen Förderstrecke (5) transportierbar sind
wobei die Vorrichtung zwei in der Förderrichtung hintereinanderliegende Bestückplätze (7) für die Substrate (6) aufweist,
wobei die Vorrichtung an jedem der Bestückplätze zumindest eine Positioniereinrichtung (4, 20) für jeweils einen in zwei Koordinatenrichtungen verfahrbaren Bestückkopf (14) zum Handhaben der Bauteile (15) aufweist und
wobei die Positioniereinrichtungen (4, 20) an einem Träger (3, 23) eines Chassis (1) der Vorrichtung verankert sind,
**dadurch gekennzeichnet, daß** sich der Träger (3, 23) oberhalb der Bestückplätze (7) in der Förderrichtung der Substrate (6) einstückig über beide Bestückplätze (7) erstreckt und zu beiden Seiten an senkrechten Endstützen (10) des Chassis (1) gehalten ist,
daß die Positioniereinrichtungen (4, 20) für die Bestückköpfe (14) auf der Unterseite des Trägers (3, 23) angeordnet sind und
daß der Träger (3, 23) zwischen den beiden Bestückplätzen zu beiden Seiten der Positionierbereiche der Bestückköpfe (14) an Mittelstützen (8) des Chassis (1) befestigt ist.

2. Vorrichtung nach Anspruch 1,
**dadurch gekennzeichnet , daß** sich die wandartigen Mittelstützen (8) von oben gesehen in der Förderrichtung der Substrate (6) erstrecken und nach oben hin dachartig schräg gegeneinander geneigt sind.

3. Vorrichtung nach Anspruch 1 oder 2,
**dadurch gekennzeichnet , daß** sich die wandartigen Endstützen (10) senkrecht zur Förderrichtung erstrecken.

4. Vorrichtung nach Anspruch 1, 2 oder 3,
**dadurch gekennzeichnet , daß** der plattenartige Träger (3, 23) an den Stützen lösbar befestigt ist und in seinen Eckbereichen Ausnehmungen aufweist.

5. Vorrichtung nach Anspruch 1
**dadurch gekennzeichnet, daß** das Chassis (1) einen kreuzförmigen Grundkörper (2) aufweist, an dessen Enden die Endstützen (10) und die Mittelstützen (8) angesetzt sind.

6. Vorrichtung nach Anspruch 5,
**dadurch gekennzeichnet, daß** der Grundkörper (2) mit den Endstützen (10) und den Mittelstützen (8) als einstückiges Gußteil ausgebildet ist.

7. Vorrichtung nach Anspruch 6,
**dadurch gekennzeichnet, daß** der hohle Grundkörper (2) Aufnahmen für Hilfsaggregate und/oder andere Hilfseinrichtungen aufweist.

8. Vorrichtung nach Anspruch 7,
**dadurch gekennzeichnet, daß** in den Grundkörper (2) unterhalb der Förderstrecke (5) ein Transportstrecke (19) für die Substrate (6) einsetzbar ist.

9. Vorrichtung nach einem der vorhergehenden Ansprüche,
**dadurch gekennzeichnet , daß** am Träger (3, 23) Montageplätze für mehrere der Positioniereinrichtungen (4, 20) vorgesehen sind.

10. Vorrichtung nach Anspruch 9,
**dadurch gekennzeichnet,**
**daß** zu beiden Seiten der Förderstrecke (5) im Bereich des Bestückplatzes Stellplätze für Zuführeinrichtungen (11) für die Bauteile angeordnet sind,
**daß** über jedem der Bestückplätze (7) eine Positioniereinrichtung (4) angeordnet ist,
**daß** die Positioniereinrichtung (4) aus einer am Träger (3) befestigten Längsführung (12) und einem sich zu dieser quer erstreckenden Positionierarm (13) gebildet ist, daß sich die Längsführung (12) in der Mitte über dem Bestückfeld in der Förderrichtung der Substrate (6) erstreckt und
**daß** der Positionierarm (13) zu beiden Seiten der Längsführung (12) bis über die Stellplätze für die Zuführeinrichtungen (11) ragt.

11. Vorrichtung nach Anspruch 9,
**dadurch gekennzeichnet,**
**daß** über jedem der Bestückplätze (7) zwei der Positioniereinrichtungen (20) mit zwei der Bestückköpfe (14) zum wechselweisen Bestücken des Substrats (6) vorgesehen sind,
**daß** sich die Längsführung (21) quer zur Förderrichtung erstreckt,
**daß** auf der beiden Positioniereinrichtungen gemeinsamen Längsführung (21) zwei der Positionierarme (22) verfahrbar sind

12. Vorrichtung nach einem der vorhergehenden Ansprüche,
**dadurch gekennzeichnet , daß** auf der Oberseite des Trägers (3) Stellplätze für Bedien- und/oder elektronische Hilfseinrichtungen vorgesehen sind.

## Claims

1. Device for placement of electrical components (15) on substrates (6),
where the substrates (6) can be transported through the device on a linear conveyor path (5)
Where the device features two placement stations (7) for the substrates (6) arranged alongside each other in the direction of transport, where the device at each of the placement stations features at least one positioning device (4, 20) for a placement head (14) movable in two coordinate directions for handling the components (15) and
where the positioning devices (4, 20) are anchored on a carrier (3, 23) of a chassis (1) of the device,
**characterized in that** the carrier (3, 23) extends over the placement stations (7) in the direction of travel of the substrates (6) in one piece over both placement stations (7) and is held on both sides on vertical end supports (10) of the chassis (1),
the positioning devices (4, 20) for the placement heads (14) are arranged on the underside of the carrier (3, 23) and
the carrier (3, 23) is attached between the two placement stations on both sides of the positioning areas of the placement heads (14) to centre supports (8) of the chassis (1).

2. Device in accordance with Claim 1,
**characterized in that** the wall-type centre supports (8) viewed from above, extend in the direction of travel of the substrates (6) and are inclined upwards at an angle to each other in a roof shape.

3. Device in accordance with Claim 1 or 2,
**characterized in that**, the wall-type end supports (10) extend at right angles to the direction of transport.

4. Device in accordance with Claim 1, 2 or 3,
**characterized in that** the plate-type carrier (3, 23) is attached to the supports to allow removal and features cutouts in its corner areas.

5. Device in accordance with Claim 1,
**characterized in that** the chassis (1) features a cross-shaped base unit (2) on the ends of which the end supports (10) and the centre supports (8) are placed.

6. Device in accordance with Claim 5,
**characterized in that** the base unit (2) is embodied with the end supports (10) and the centre supports (8) as a one-piece casting.

7. Device in accordance with Claim 6,
**characterized in that** the hollow base unit (2) features openings for auxiliary units and/or other auxiliary devices.

8. Device in accordance with Claim 7,
**characterized in that** in the base unit (2) below the conveyor path (5) a transport path (19) for the substrates (6) can be used.

9. Device in accordance with one of the previous claims,
**characterized in that** mounting locations for a number of the positioning devices (4, 20) are provided on the carrier (3, 23).

10. Device in accordance with Claim 9,
**characterized in that**
on both sides of the conveyor path (5) in the area of the component placement station mounting locations are arranged for feed devices (11) for the components,
a positioning device (4) is arranged above each of the placement stations (7),
the positioning device (4) is formed from a longitudinal guide (12) attached to the carrier (3) and a positioning arm (13) extending at right angles to this, the longitudinal guide (12) extends in the centre over the placement field in the direction of travel of the substrates (6) and
the positioning arm (13) protrudes to both sides of the longitudinal guide (12) over the mounting locations for the feed devices (11).

11. Device in accordance with Claim 9,
**characterized in that**
over each of the placement stations (7) two of the positioning devices (20) are provided with two of the placement heads (14) for alternate component placement on the substrate (6), the longitudinal guide (21) extends at right angles to the direction of transport, two of the positioning arms (22) are movable on the longitudinal guide (21) common to the two positioning devices

12. Device in accordance with one of the previous claims,
**characterized in that** on the upper side of the carrier (3) mounting locations are provided for control and/or electronic auxiliary devices.

## Revendications

1. Dispositif pour l'équipement de substrats (6) avec des composantes électriques (15),
les substrats (6) étant transportables à travers le dispositif sur une voie de transport linéaire (5), le dispositif étant muni de deux postes de montage (7) pour les substrats (6) situés l'un derrière l'autre dans le sens de transport, le dispositif étant muni à chacun des postes de montage d'au moins un système de positionnement (4, 20) pour respectivement une tête de montage (14) déplaçable dans deux sens de coordonnées, pour la manipulation des composantes (15) et
les systèmes de positionnement (4, 20) étant ancrés sur un support (3, 23) d'un châssis (1) du dispositif,
**caractérisé en ce qu'**au-dessus des postes de montage (7), dans le sens de transport des substrats (6), le support (3, 23) s'étend en monobloc par-dessus les postes de montage (7), et qu'il est maintenu sur les deux côtés à des appuis d'extrémités (10) verticaux du châssis (1),
**en ce que** les systèmes de positionnement (4, 20) pour les têtes de montage (14) sont disposés sur la face inférieure du support (3, 23) et
**en ce que** le support (3, 23) est fixé entre les deux postes de montage, des deux côtés des zones de positionnement des têtes de montage (14), sur des appuis centraux (8) du châssis (1).

2. Dispositif selon la revendication 1,
**caractérisé en ce que**, vus par le dessus, les appuis centraux du type d'une paroi (8) s'étendent dans le sens de transport des substrats (6) et qu'ils sont inclinés en oblique l'un contre l'autre vers le haut, à la manière d'un toit.

3. Dispositif selon l'une quelconque des revendications 1 ou 2,
**caractérisé en ce que** les appuis d'extrémités (10) du type d'une paroi s'étendent à la perpendiculaire du sens de transport.

4. Dispositif selon l'une quelconque des revendications 1, 2 ou 3,
**caractérisé en ce que** le support (3, 23) du type d'une plaque est fixé de façon amovible sur les appuis et que dans ses zones angulaires, il est muni d'évidements.

5. Dispositif selon la revendication 1,
**caractérisé en ce que** le châssis (1) est muni d'un corps de base (2) cruciforme, sur les extrémités duquel les appuis d'extrémités (10) et les appuis centraux (8) sont ajoutés.

6. Dispositif selon la revendication 5,
**caractérisé en ce que** le corps de base (2) est conçu sous forme d'une pièce en fonte monobloc avec les appuis d'extrémités (10) et les appuis centraux (8).

7. Dispositif selon la revendication 6,
**caractérisé en ce que** le corps de base (2) creux est muni de pièces de réception pour des agrégats auxiliaires et/ou d'autres système auxiliaires.

8. Dispositif selon la revendication 7,
**caractérisé en ce qu'**une ligne de transport (19) pour les substrats (6) est intégrable dans le corps de base (2), au-dessous de la voie de transport (5).

9. Dispositif selon l'une quelconque des revendications précédentes,
**caractérisé en ce que** des postes de monture pour plusieurs des systèmes de positionnement (4, 20) sont prévus sur le support (3, 23).

10. Dispositif selon la revendication 9,
**caractérisé en ce que** des deux côtés de la voie de transport (5), dans la zone du poste de montage sont disposés des postes de dépose pour des systèmes d'amenée (11) pour les composantes, **en ce qu'**un système de positionnement (4) est disposé au-dessus de chacun des postes de montage (7), **en ce que** le système de positionnement (4) est constitué d'un guidage longitudinal (12) fixé sur le support (3) et d'un bras de positionnement (13) s'étendant à la transversale vers ce dernier, **en ce que** le guidage longitudinal (12) s'étend au milieu, au-dessus du champ de montage dans le sens de transport des substrats (6) et **en ce que** le bras de positionnement (13) saillit vers les deux côtés du guidage longitudinal (12), jusqu'au-dessus des postes de dépose pour les systèmes d'amenée (11).

11. Dispositif selon la revendication 9,
**caractérisé en ce que** deux des systèmes de positionnement (20) sont prévus au-dessus de chacun des postes de montage (7), avec deux des têtes de positionnement (14), pour l'équipement à tour de rôle du substrat (6), **en ce que** le guidage longitudinal (21) s'étend à la transversale du sens de transport, **en ce que** deux des bras de positionnement (22) sont déplaçables sur le guidage longitudinal (21) commun aux deux systèmes de positionnement.

12. Dispositif selon l'une quelconque des revendications précédentes,
**caractérisé en ce que** des emplacements de dépose pour des systèmes de service et/ou des systèmes électroniques auxiliaires sont prévus sur la face supérieure du support (3).
